# EUROPÄISCHE PATENTSCHRIFT

(11) **EP 4 041 973 B1**
(45) Veröffentlichungstag und Bekanntmachung des Hinweises auf die Patenterteilung: **28.01.2026**
(21) Anmeldenummer: 20760439.8
(22) Anmeldetag: 19.08.2020
(51) Int. Cl.: E05B 81/76, H03K 17/95, H03K 17/97

(54) **INDUKTIVE SENSORANORDNUNG ZUR ERFASSUNG EINER LAGEÄNDERUNG EINES BETÄTIGUNGSELEMENTS**
INDUCTIVE SENSOR ASSEMBLY FOR DETECTING A CHANGE IN POSITION OF AN ACTUATING ELEMENT
ENSEMBLE CAPTEUR INDUCTIF SERVANT À DÉTECTER UN CHANGEMENT DE POSITION D'UN ÉLÉMENT D'ACTIONNEMENT

(30) Priorität: 18.12.2019 DE 102019134953
(43) Veröffentlichungstag der Anmeldung: 17.08.2022
(73) Patentinhaber: Huf Hülsbeck & Fürst GmbH & Co. KG, 42551 Velbert (DE)
(72) Erfinder: ZIEGLER, Alexander, 42489 Wülfrath (DE); CHABROWSKI, Christian, 45472 Mülheim Nordrhein-Westfalen (DE)
(74) Vertreter: Zenz Patentanwälte Partnerschaft mbB
(86) Internationale Anmeldenummer: PCT/EP2020/073230
(87) Internationale Veröffentlichungsnummer: WO 2021/121682

(56) Entgegenhaltungen:
- WO-A1-2019/122867
- GB-A- 2 494 183
- US-A1- 2019 094 404
- US-B2- 10 428 562

## Beschreibung

Die Erfindung betrifft eine induktive Sensoranordnung. Die Erfindung betrifft außerdem eine Betätigungsanordnung.

Induktive Sensoranordnungen spielen bei modernen Kraftfahrzeugen zunehmend eine Rolle, beispielsweise zur Erkennung einer Betätigung eines sogenannten feststehenden Türgriffs und eine dadurch ausgelöste Auslösung der Türöffnung. Das Funktionsprinzip induktiver Sensoranordnungen beruht auf der Erkennung einer Veränderung eines elektromagnetischen Felds, wenn ein metallisches oder ferromagnetisches Betätigungselement sich in dem elektromagnetischen Feld bewegt. Der zu Grunde liegende physikalische Effekt ist die Änderung der Induktivität und/oder der Güte der Induktivität infolge einer Lageänderung des leitfähigen und/oder ferromagnetischen Elements relativ zu dem die Induktivität erzeugenden Bauteil. Bei dem leitfähigen oder ferromagnetischen Element kann es sich beispielsweise um einen Betätigungsbereich einer Handhabe eines Türgriffs oder um einen Teil eines Betätigungsbereichs der Handhabe des Türgriffs handeln. Dadurch, dass mit induktiven Sensoren auch geringfügige Lageänderungen, beispielsweise im Mikrometerbereich, erkannt werden können, ist die Nutzung induktiver Sensoren insbesondere bei den zunehmend verwendeten sogenannten feststehenden Türgriffen interessant.

Bei der Bereitstellung von Betätigungsanordnungen mit induktiven Sensoranordnungen ist eine zuverlässige Erfassung einer Ortsänderung eines metallischen Betätigungselements wichtig. Außerdem ist wünschenswert, dass die Betätigungsanordnung wirtschaftlich herstellbar ist.

Die GB 2 494 183 A beschreibt ein Effektgerät zur Bereitstellung eines Ausgangssignals aus einem Eingangssignal, das von einem elektronischen Musikinstrument oder einem Mikrophon stammt. Die GB 2 494 183 A beschreibt unter anderem die Nutzung eines Schwingkreises, auch aufweisend eine induktive Spule.

Die US 2019/094404 A1 beschreibt einen Annäherungssensor, der die Anwesenheit oder die Abwesenheit eines Objekts erkennt und ausgibt.

Die US 10 428 562 B2 offenbart eine Vorrichtung zum Erfassen der Anwesenheit eines Benutzers und einen Fahrzeugtürgriff, der diese Vorrichtung umfasst.

Die WO 2019/122867 A1 offenbart Erfassungssysteme und -verfahren für Tastaturen, beispielsweise für Musikinstrumente.

Aufgabe der Erfindung ist es, eine Alternative für bereits existierende Betätigungsanordnungen bereitzustellen. Die zu findenden Überlegungen sollen eine ausreichend zuverlässige Erfassung einer Ortsänderung eines Betätigungselements erwarten lassen und eine Herstellung einer Betätigungsanordnung mit vernünftiger Wirtschaftlichkeit erlauben.

Die Aufgabe wird gelöst mit einem Kraftfahrzeug mit einer Betätigungsanordnung, wobei die Betätigungsanordnung eine induktive Sensoranordnung aufweist, mit den Merkmalen des Anspruchs 1.

Es ist eine induktive Sensoranordnung zur Erfassung einer Lageänderung eines metallischen Betätigungselements, vorgesehen. Die Sensoranordnung weist wenigstens die nachfolgend genannten Bestandteile auf:
- einen LC-Schwingkreis mit einem induktiven Glied (L), bevorzugt einer Spule oder einer Kombination mehrerer Spulen, und mit einem kapazitiven Glied (C), beispielsweise einem Kondensator oder mehreren Kondensatoren;
- einen Anregungsversorger, der zur Anregung des LC-Schwingkreises mit einer Anregungsspannung (U) mit dem LC-Schwingkreis gekoppelt ist,
- ein zwischen dem Anregungsversorger und dem LC-Schwingkreis angeordnetes Entkopplungsglied,
- eine Auswerteanordnung zum Auswerten des über dem Schwingkreis abfallenden Signals.

Als Entkopplungsglied kann insbesondere ein hochohmiger Vorwiderstand vorgesehen sein, der zwischen dem Anregungsversorger und dem Schwingkreis geschaltet ist. Der hochohmige Vorwiderstand kann beispielsweise einen Widerstandswert zwischen 1 kOhm und 10 kOhm, bevorzugt zwischen 3 kOhm und 7 kOhm, betragen. Selbstverständlich kann das Entkopplungsglied auch mehr als ein Bauteil aufweisen, wesentlich ist die Funktionalität der hochohmigen Entkopplung.

Die Anregungsspannung wird von dem Anregungsversorger bevorzugt als Folge von Spannungspulsen ausgegeben, besonders bevorzugt als Folge von Rechteckpulsen. Die Spannungspulse können beispielsweise mit einer Arbeitsfrequenz zwischen 1 MHz und 10 MHz, bevorzugt 5 MHz bis 10 MHz, besonders bevorzugt 7 MHz bis 9 MHz, ausgegeben werden. Alternativ sind aber auch andere Varianten der Anregungsspannungen denkbar, beispielsweise eine Anregung mittels Anregungssignals, das einem Sinusverlauf folgt, das heißt: mit einer Anregungsspannung, die als Sinusfunktion beziehungsweise Sinusschwingung in Abhängigkeit von der Zeit beschrieben werden. Die Arbeitsfrequenzen können in diesem Fall ebenfalls zwischen 1 MHz und 10 MHz, bevorzugt 5 MHz bis 10 MHz, besonders bevorzugt 7 MHz bis 9 MHz, betragen

Als Anregungsversorger kann beispielsweise ein NOC, *numerically controlled oscillator,* oft auch als DCO, *digitally controlled oscillator,* verwendet werden wodurch sich der Vorteil ergibt, dass ein zur Ausgabe von Spannungspulsen erforderlicher Zeitgeber bereits Bestandteil des Anregungsversorgers ist. Der Anregungsversorger kann auch als Signalquelle bezeichnet werden; der Begriff der Signalquelle ist in dem Zusammenhang mit dem Betrieb eines Schwingkreises geläufig.

Der LC-Schwingkreis ist bevorzugt ein Parallelschwingkreis, die Sensoranordnung ist prinzipiell aber auch mit einem als Serienschwingkreis ausgebildeten LC-Schwingkreis funktionsfähig.

Bevorzugt ist eine konstruktiv einfache Variante, in welcher genau eine Spule als induktives Glied und genau ein Kondensator als kapazitives Glied den LC-Schwingkreis bilden. Alternativ kann aber auch vorgesehen sein, dass mehrere induktive Bauteile und/oder mehrere kapazitive Bauteile vorgesehen sind, wobei dann das kapazitive Glied die kapazitive Gesamtwirkung beziehungsweise das induktive Glied die induktive Gesamtwirkung im Rahmen einer Ersatzschaltbildbetrachtung repräsentieren.

Insbesondere kann vorgesehen sein, dass wenigstens der Anregungsversorger, der Schwingkreis, die Leitungsverbindung, und/oder das Entkopplungsglied in einem selben Mikrocontroller enthalten sind, bevorzugt außerdem die Auswerteanordnung. Die Bereitstellung aller oder vieler Funktionalitäten der Sensoranordnung innerhalb von einem Mikrocontroller führt dazu, dass die Sensoranordnung sehr kostengünstig durch Programmierung eines Mikrocontrollers bereitgestellt werden kann.

In einer Ausführungsform weist die Auswerteanordnung eine Gleichrichterschaltung auf.

Es ist also eine induktive Sensoranordnung zur Erfassung einer Lageänderung eines Betätigungselements vorgeschlagen. Zur Ermittlung der Lageänderung des Betätigungselements werden elektromagnetische Eigenschaften des LC-Schwingkreises gemessen, wobei bei Lageänderung des LC-Schwingkreises eine Verstimmung des LC-Schwingkreises stattfindet:
- Einen LC-Schwingkreis mit dem induktiven Glied (L) und mit dem kapazitiven Glied (C).
- Einen Anregungsversorger, der zur Anregung des LC-Schwingkreises mit einer Anregungsspannung (U) mit dem LC-Schwingkreis gekoppelt ist. Bevorzugt ist der Anregungsversorger ein Pin-Controller, dessen Ausgangspin über einen Leiter mit dem LC-Schwingkreis gekoppelt ist, wobei zwischen Ausgangspin und LC-Schwingkreis ein Entkopplungswiderstand mit hohem Widerstandswert, beisspielsweise zwischen 1 kOhm und 10 kOhm, bevorzugt zwischen 4 kOhm und 6 kOhm, angeordnet ist.
- Eine Auswerteanordnung zum Auswerten des über dem Schwingkreis abfallenden Signals. Bevorzugt ist die Auswerteanordnung eine Reihenschaltung aus Gleichrichterschaltung und ADC, wobei besonders bevorzugt Gleichrichterschaltung und ADC zur Signalglättung über ein weiteres kapazitives Element, optional zusätzlich über einen hochohmigen Widerstand.

Die Gleichrichterschaltung führt herbei, dass anstelle einer hochfrequenten Wechselspannung ein Gleichspannungssignal vorliegt. In der bevorzugten Ausgestaltung, in der die Gleichrichterschaltung aus Diode und parallel zu dem Schwingkreis angeordneter Kapazität besteht, ist die über der Kapazität des Gleichrichters anfallende Spannung ein Maß für die Amplitude der Wechselspannung. Voraussetzung ist natürlich, dass die Kapazität groß genug ist, was dem Fachmann bei Auslegung obliegt. Am ADC wird die Spannung über der Kapazität ermittelt und beispielsweise mit einem Sollwert verglichen und/oder auf ein Unterschreiten eines unteren Schwellwerts hin geprüft und/oder auf ein Überschreiten des oberen Schwellwerts hin geprüft. Dies ist die in der vorliegenden Anmeldung vorgenommene Auswertung des über dem Schwingkreis abfallenden Signal, indirekt über den gleichgerichteten Spannungswert. In dem Fall, dass eine oder mehrere der Bedingungen in vorab festgelegter und von der konkreten Auslegung der Sensoranordnung abhängiger Weise erfüllt ist beziehungsweise sind, wird das Betätigungselement als von der nicht betätigten Lage abweichend erkannt und dadurch eine Betätigung festgestellt. Dies kann eine mit der Auswerteanordnung gekoppelte Auslöseschaltung zur Ausgabe eines Betätigungssignals veranlassen.

Ein großer Vorteil der beschriebenen Vorgehensweise besteht darin, dass eine aufwändige und fehleranfällige zeitaufgelöste Messung einer hochfrequent zeitabhängigen Spannung auf die Messung eines gleichgerichteten - und dadurch deutlich weniger zeitabhängigen - Signals zurückgeführt wird. Die Umsetzung dieser Messung führt dadurch zu einer robusten und von Abweichungen in der Zeiterfassung beziehungsweise der Genauigkeit eines Zeitgebers weniger abhängigen Erkennung einer Lageänderung.

Der Anregungsversorger ist in einer bevorzugten Ausführung eingerichtet, die Anregungsspannung mit einer Arbeitsfrequenz auszugeben, die der Eigenfrequenz des Schwingkreises entspricht oder auf diese abgestimmt ist. Auf die Eigenfrequenz abgestimmt sein heißt bevorzugt, dass empirisch eine Anregungsspannung gefunden wird, welche bei möglichst geringen Lageänderungen bereits deutliche Effekte hervorruft. Konkret bedeutet dies, dass beispielsweise ein Arbeitspunkt der Anregungsspannung gefunden wird, der in der Signal-Frequenz-Kurve (mit dem Signal auf y-Achse) eine möglichst große Steigung aufweist. Typischerweise handelt es sich dabei um eine Frequenz, die nahe an der Eigenfreuenz ist. Beispielsweise kann vorgesehen sein, dass die Anregungsspannung weniger als 5 Prozent von der Eigenfrequenz des Schwingkreises abweicht. Eine Arbeitsfrequenz in Nähe der Eigenfrequenz des Schwingkreises hat zur Folge, dass bereits eine geringe Änderung der Induktivität des induktiven Glieds und/oder der Güte der Induktivität des induktiven Glieds zu einer starken Änderung des über dem Schwingkreis abfallenden Signals führt, was in der Folge zu einer hohen Messempfindlichkeit der induktiven Sensoranordnung führt. Insbesondere in einer erfindungsgemäßen Ausführung, welche eine Gleichrichterschaltung als Bestandteil der Auswerteanordnung aufweist, bietet sich an, einen von dem gleichgerichteten Signal abhängigen Parameter auszuwerten. Bevorzugt ist, dass eine gleichgerichtete Spannung gemessen wird. Es bietet sich an, eine solche Auswertung erst zu einem Zeitpunkt durchzuführen, in dem eine Sättigung des gleichgerichteten Signals stattgefunden hat, beispielsweise nach Ablauf von wenigstens fünf, bevorzugt wenigstens zehn, Anregungsperioden.

Die Gleichrichterschaltung weist erfindungsgemäß eine Diode und eine, bevorzugt parallel zum Schwingkreis geschaltete, Kapazität (C_D) auf. Diese Ausführung hat den Vorteil, besonders einfach und dadurch kostengünstig zu sein.

Erfindungsgemäß ist die Gleichrichterschaltung zwischen dem LC-Schwingkreis und einem ADC der Auswerteanordnung angeordnet ist, wobei die Auswerteanordnung eingerichtet ist, einen am Gleichrichter gleichgerichteten Spannungswert mit dem ADC zu erfassen und in Abhängigkeit von dem erfassten Spannungswert eine Lageänderung als vorhanden zu erkennen.

Bevorzugt ist vorgesehen, dass die Auswerteanordnung ein in dem Mikrocontroller vorhandenes ADC ist, alternativ ein ADC als Bestandteil aufweist.

Besonders bevorzugt ist die Auswerteanordnung eingerichtet, eine Lageänderung als vorhanden zu erkennen, wenn ein oberer Schwellspannungswert überschritten ist oder wenn ein unterer Schwellspannungswert unterschritten ist.

Gemäß einer Ausführung der Sensoranordnung ist die Auswerteanordnung eingerichtet, eine Lageänderung genau dann als vorhanden zu erkennen, wenn ein oberer Schwellspannungswert überschritten ist oder wenn ein unterer Schwellspannungswert unterschritten ist. Insbesondere kann vorgesehen sein, dass die Lageänderung genau dann als vorhanden zu erkennen, wenn ein oberer Schwellspannungswert überschritten ist oder wenn ein unterer Schwellspannungswert unterschritten ist.

In einer alternativen Ausführungsform der Erfindung weist die Auswerteanordnung keine Gleichrichterschaltung auf und ein ADC der Auswerteanordnung erfasst eine am Schwingkreis abfallende Spannung. In dieser Ausführung ist wesentlich, dass eine Trägheit des ADC derart an eine Arbeitsfrequenz des Anregungsversorgers angepasst ist, dass eine Mindestmessdauer des ADC wenigstens eine Periodendauer der Schwingkreisanregung dauert, bevorzugt zwischen 5 und 1000 Periodendauern der Schwingkreisanregung, besonders bevorzugt zwischen 5 und 100 Periodendauern der Schwingkreisanregung, noch bevorzugter zwischen 5 und 20 Periodendauern der Schwingkreisanregung. In Simulationen haben sich 10 Periodendauern der Schwingkreisanregung und benachbarte Werte als besonders gut tauglich erwiesen. Dadurch wird bewirkt, dass ein der ADC die zeitabhängige Spannungsveränderung nicht mitvollziehen kann, sondern für den ADC die zeitabhängige Spannung einen im Wesentlichen zeitunabhängigen Messwert der Spannung zur Folge hat. Diese Ausführungsform macht sich also einen Nachteil von vergleichsweise kostengünstigen ADCs zu Nutze, nämlich eine schlechte Zeitauflösung.

Erfindungsgemäß ist eine Betätigungsanordnung an einem Kraftfahrzeug vorgesehen, wobei die Betätigungsanordnung eine Sensoranordnung nach einem der vorhergehenden Ansprüche und ein metallisches Betätigungselement aufweist, wobei das metallische Betätigungselement bei Betätigung eine Lageänderung vollzieht relativ zu dem induktiven Glied.

Das metallische Betätigungselement ist relativ zu dem elektromagnetischen Feld des induktiven Glieds beweglich oder verformbar, was beides von dem Oberbegriff der Lageänderung umfasst ist. Durch die Lageänderung ergibt sich die eingangs bereits erläuterte Änderung von Induktivität und/oder Ersatzinduktivität und/oder Güte der Induktivität des induktiven Glieds, wodurch wiederum eine Verstimmung des LC-Schwingkreises herbeigeführt wird und dadurch der Wert der gleichgerichteten Spannungsamplitude gegenüber der im Gleichgewichtszustand vorliegenden Spannungsamplitude verändert wird. Aus der Veränderung der Spannungsamplitude kann sodann unmittelbar auf die Lageänderung des metallischen Betätigungselements rückgeschlossen werden. Eine Lageänderung kann durch die Auswerteanordnung dann beispielsweise als vorhanden aufgefasst werden, wenn eine, durch den Fachmann in Abhängigkeit von der geforderten Genauigkeit und/oder den tolerierten False-Positive-Messungen bestimmte, obere Schwellwertspannung überschritten wird und/oder eine untere Schwellwertspannung unterschritten wird.

Der Begriff des metallischen Betätigungselements bezeichnet dabei die Eigenschaft, das durch das induktive Glied erzeugte elektromagnetische Feld, und damit beispielsweise die Güte der Induktivität des induktiven Glieds, zu beeinflussen. Hierzu kann das metallische Betätigungselement beispielsweise aus einem Metall bestehen oder ein Metall aufweisen, aber das Betätigungselement kann auch durch andere Werkstoffe als Metalle als metallisches Betätigungselement qualifiziert werden, beispielsweise durch einen Werkstoff, der in zur Beeinflussung des elektromagnetischen Felds ausreichender Weise metallische Leitungseigenschaften aufweist, wie es beispielsweise bei einigen Übergangsmetallnitriden wie beispielsweise Titannitrid der Fall ist.

Es obliegt selbstredend dem mit der Ausführung der Erfindung beauftragten Fachmann, Dimensionierung von Schwingkreis und Anregungsspannung einerseits sowie Ausformung und Positionierung des Betätigungselements andererseits aufeinander hin anzupassen und beide abzustimmen mit einer minimalen Veränderung des Spannungsverlaufs am Ausgang der Gleichrichterschaltung von welcher an von einer Lageänderung des Betätigungselements ausgegangen werden kann beziehungsweise soll. Dies ist aber für die prinzipielle Funktionsweise der vorliegenden Erfindung nicht wesentlich, solange das Betätigungselement bei Ortsänderung innerhalb vorgegebener Parameter das elektromagnetische Feld des Betätigungselements beeinflusst und diese Beeinflussung in reproduzierbarer Weise zu einer sicher erkennbaren Phasenverschiebung führt, die oberhalb eines vom Fachmann festgelegten Werts als Erkennung der Betätigung der Lageänderung betrachtet wird. Eine solche Auslegung an sich stellt den Fachmann vor keine prinzipiellen Herausforderungen, sondern es sind fachübliche Abwägungen zu treffen, beispielsweise zwischen geforderter Empfindlichkeit einer Erkennung der Lageänderung einerseits und toleriertem Ausmaß an False-Positive-Erkennungen.

Bevorzugt ist die Betätigungsanordnung ein Türgriff einer Fahrzeugtür oder einer Fahrzeugklappe, wobei die induktive Sensoranordnung innerhalb des Türgriffs angeordnet ist. Besonders bevorzugt ist das Betätigungselement an dem Türgriff angeordnet oder Bestandteil des Türgriffs, bevorzugt Bestanteil eines Hüllenabschnitts des Türgriffs.
Fig. 1a und 1b: Prinzipskizzen einer Betätigungsanordnung 1;
Fig. 2: schematisches Schaltbild einer induktiven Sensoranordnung;

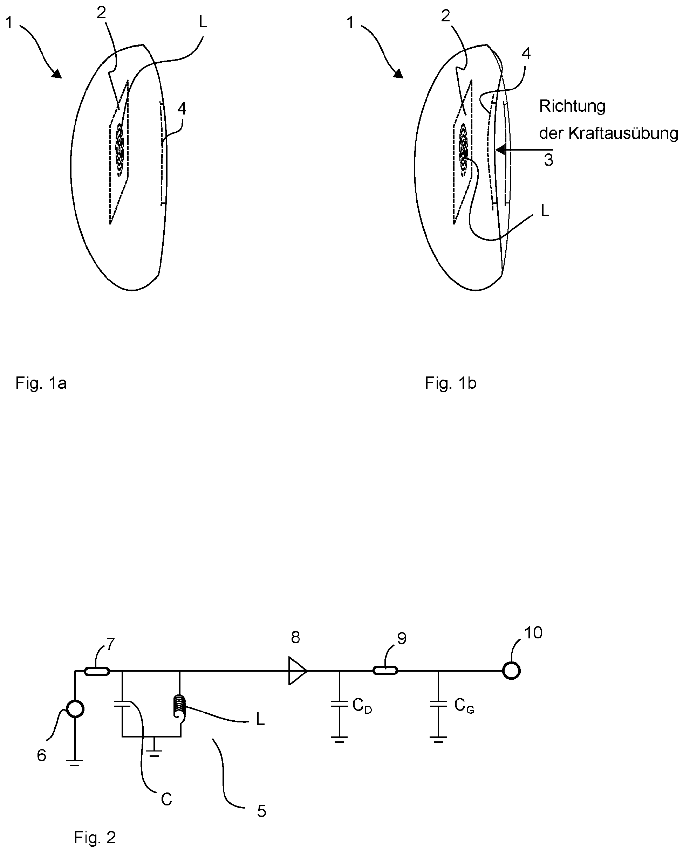

In Fig. 1a ist eine schematische Querschnittsdarstellung einer Betätigungsanordnung 1 eines Kraftfahrzeugs dargestellt. Die Betätigungsanordnung 1 ist in der beispielhaft dargestellten Ausführungsform eine Handhabe eines Türgriffs, welche im Querschnitt dargestellt ist. Innerhalb der Handhabe 1 ist eine induktive Sensoranordnung 2 dargestellt, die in der gezeigten Ausführungsform in ihrer Gesamtheit auf einer Platine angeordnet ist. Die induktive Sensoranordnung weist einen Schwingkreis mit einer Spule L auf. An dem Hüllenabschnitt des Türgriffs und innenseitig des Türgriffs ist ein als Metallfolie ausgebildetes metallisches Betätigungselement 4 angeordnet. Das metallische Betätigungselement 4 ist der Spule L der induktiven Sensoranordnung 2 gegenüberliegend angeordnet. Aufgrund des elastischen Verhaltens des Hüllenabschnitts des Türgriffs ist das metallische Betätigungselement 4 relativ zu der Sensoranordnung 2 beweglich.

In Fig. 1b ist dargestellt, wie infolge der Kraftausübung (symbolisiert durch den dargestellten Pfeil 3) eine Einwirkung auf den Hüllenabschnitt herbeigeführt ist. Infolge der Krafteinwirkung hat das als Metallfolie ausgebildete metallische Betätigungselement 4 eine Lageänderung vollzogen. Die Lageänderung ist Konsequenz einer abschnittsweisen Ortsänderung des Betätigungselements 4 zu der Sensoranordnung 2 als Folge der Verformung des Betätigungselements **4.** Die Ortsänderung des Betätigungselements ist insbesondere auch relativ zu der Spule L der Sensoranordnung 2 aufgetreten. Die Sensoranordnung 2 dient dem Zweck, die in der Verformung des Betätigungselements 4 sich ausprägende Betätigung zu erkennen.

In Fig. 2 ist ein Ausführungsbeispiel einer erfindungsgemäßen induktiven Sensoranordnung zu erkennen. Die Sensoranordnung weist einen LC-Schwingkreis 5 auf, der das induktive Glied L und das kapazitive Glied C aufweist. Das induktive Glied repräsentiert den Bestandteil der Sensoranordnung, welcher für die Erkennung der Lageänderung eines metallischen und/oder ferromagnetischen Betätigungselements die Funktionalität bereitstellt. In der gezeigten Ausführungsform ist der Schwingkreis 5 ein Parallelschwingkreis, der über den Entkopplungswiderstand 7 mit dem Anregungsversorger 6 gekoppelt ist. Der Anregungsversorger 6 ist ein Pin-Controller, dessen Ausgangspin das Anregungssignal für den Schwingkreis 5 bereitstellt. Der Entkopplungswiderstand weist in der gezeigten Darstellung einen Widerstandswert von 5 kOhm auf. Die Auswerteanordnung zum Auswerten des über dem Schwingkreis abfallenden Signals wird gebildet aus dem Gleichrichter 8, der Kapazität C_{D} (auch als C_D bezeichnet), die zusammen die Gleichrichterschaltung bilden, gemeinsam mit dem ADC 10 und Widerstand 9 und Kapazität C_{G}, die zur Signalglättung genutzt werden, für die eigentliche Funktionalität aber nicht zwingend erforderlich sind.

## Patentansprüche

1. Kraftfahrzeug mit einer Betätigungsanordnung, wobei die Betätigungsanordnung eine induktive Sensoranordnung (2) zur Erfassung einer Lageänderung eines metallischen Betätigungselements und das metallische Betätigungselement (4) aufweist, wobei das metallische Betätigungselement (4) bei Betätigung eine Lageänderung vollzieht relativ zu einem induktiven Glied (L),
wobei die Sensoranordnung aufweist:
- einen LC-Schwingkreis mit dem induktiven Glied (L) und mit einem kapazitiven Glied (C),
- einen Anregungsversorger, der zur Anregung des LC-Schwingkreises mit einer Anregungsspannung (U) mit dem LC-Schwingkreis gekoppelt ist,
- ein zwischen dem Anregungsversorger und dem LC-Schwingkreis angeordnetes Entkopplungsglied,
- eine Auswerteanordnung zum Auswerten des über dem Schwingkreis abfallenden Signals,
wobei die Auswerteanordnung eine Gleichrichterschaltung aufweist, wobei die Gleichrichterschaltung eine Diode und eine, bevorzugt parallel zum Schwingkreis geschaltete, Kapazität (C_D) aufweist,
wobei die Gleichrichterschaltung zwischen dem LC-Schwingkreis und einem ADC der Auswerteanordnung angeordnet ist, wobei die Auswerteanordnung eingerichtet ist, einen am Gleichrichter gleichgerichteten Spannungswert mit dem ADC zu erfassen und in Abhängigkeit von dem erfassten Spannungswert eine Lageänderung als vorhanden zu erkennen.

2. Kraftfahrzeug nach Anspruch 1, wobei der Anregungsversorger eingerichtet ist, die Anregungsspannung (U) mit einer Arbeitsfrequenz (f) auszugeben, die der Eigenfrequenz des Schwingkreises entspricht oder auf diese abgestimmt ist.

3. Kraftfahrzeug nach Anspruch 1 oder nach Anspruch 2, wobei die Auswerteanordnung eingerichtet ist, eine Lageänderung als vorhanden zu erkennen, wenn ein oberer Schwellspannungswert überschritten ist oder wenn ein unterer Schwellspannungswert unterschritten ist.

## Claims

1. Motor vehicle with an actuating arrangement, wherein the actuating arrangement comprises an inductive sensor arrangement (2) for detecting a change in position of a metallic actuating element and the metallic actuating element (4), wherein the metallic actuating element (4) undergoes a change in position relative to an inductive member (L) when actuated,
wherein the sensor arrangement comprises:
- an LC resonant circuit with the inductive member (L) and with a capacitive member (C),
- an excitation supply which is coupled to the LC resonant circuit with an excitation voltage (U) for exciting the LC resonant circuit,
- a decoupling element arranged between the excitation supply and the LC resonant circuit,
- an evaluation arrangement for evaluating the signal falling across the resonant circuit,
wherein the evaluation arrangement has a rectifier circuit, wherein the rectifier circuit has a diode and a capacitance (C_D) connected preferably in parallel to the resonant circuit,
wherein the rectifier circuit is arranged between the LC resonant circuit and an ADC of the evaluation arrangement, wherein the evaluation arrangement is designed to detect a voltage value rectified at the rectifier with the ADC and to recognise a change in position as present depending on the detected voltage value.

2. Motor vehicle according to claim 1, wherein the excitation supply is designed to output the excitation voltage (U) at a working frequency (f) which corresponds to or is tuned to the natural frequency of the resonant circuit.

3. Motor vehicle according to claim 1 or claim 2, wherein the evaluation arrangement is configured to detect a change in position as present when an upper threshold voltage value is exceeded or when a lower threshold voltage value is undershot.

## Revendications

1. Véhicule automobile avec un dispositif d'actionnement, dans lequel
le dispositif d'actionnement comprend un dispositif de capteur inductif (2) pour détecter un changement de position d'un élément d'actionnement métallique et l'élément d'actionnement métallique (4), l'élément d'actionnement métallique (4) effectuant un changement de position par rapport à un élément inductif (L) lors de l'actionnement,
le dispositif de capteur comprenant :
- un circuit oscillant LC avec l'élément inductif (L) et avec un élément capacitif (C),
- un générateur d'excitation qui est couplée au circuit oscillant LC pour exciter le circuit oscillant LC avec une tension d'excitation (U),
- un élément de découplage disposé entre le générateur d'excitation et le circuit oscillant LC,
- un dispositif d'évaluation pour évaluer le signal chutant aux bornes du circuit oscillant,
le dispositif d'évaluation comportant un circuit redresseur, le circuit redresseur comportant une diode et une capacité (C_D) branchée de préférence en parallèle avec le circuit oscillant,
le circuit redresseur étant disposé entre le circuit oscillant LC et un convertisseur analogique-numérique (ADC) du dispositif d'évaluation, le dispositif d'évaluation étant conçu pour détecter une valeur de tension redressée au niveau du redresseur à l'aide de l'ADC et pour reconnaître l'existence d'un changement de position en fonction de la valeur de tension détectée.

2. Véhicule automobile selon la revendication 1, dans lequel le générateur d'excitation est conçu pour délivrer la tension d'excitation (U) avec une fréquence de travail (f) qui correspond à la fréquence propre du circuit oscillant ou qui est accordée sur celle-ci.

3. Véhicule automobile selon la revendication 1 ou selon la revendication 2, dans lequel le dispositif d'évaluation est conçu pour reconnaître l'existence d'un changement de position lorsqu'une valeur de tension seuil supérieure est dépassée ou lorsqu'une valeur de tension est inférieure au seuil inférieur.
